# EUROPÄISCHE PATENTSCHRIFT

(11) **EP 0 903 791 B1**
(45) Veröffentlichungstag und Bekanntmachung des Hinweises auf die Patenterteilung: **21.11.2001**
(21) Anmeldenummer: 98110243.7
(22) Anmeldetag: 05.06.1998
(51) Int. Cl.: H01L 31/167, H01L 31/147, H01L 25/16, G02B 6/42

(54) **Bauteil zur optischen Datenübertragung**
Apparatus for optical transmission of data
Dispositif de transmission optique de données

(30) Priorität: 28.06.1997 DE 19727632
(43) Veröffentlichungstag der Anmeldung: 24.03.1999
(73) Patentinhaber: Vishay Semiconductor GmbH, 74072 Heilbronn (DE)
(72) Erfinder: Schairer, Werner, Dr., 74189 Weinsberg (DE)
(74) Vertreter: Maute, Hans-Jürgen, Dipl.-Ing.

(56) Entgegenhaltungen:
- DE-A- 2 629 356
- DE-A- 19 508 284
- GB-A- 2 011 610
- US-A- 5 140 152
- PATENT ABSTRACTS OF JAPAN vol. 017, no. 004 (P-1464), 6. Januar 1993 (1993-01-06) & JP 04 237005 A (FUJITSU LTD), 25. August 1992 (1992-08-25)

## Beschreibung

Die Erfindung betrifft ein Bauteil zur gerichteten, bidirektionalen optischen Datenübertragung nach dem Oberbegriff des Patentanspruchs 1.

Eine solche Anordnung, auch als Transceiver (aus Transmitter und Receiver) bezeichnet, wird zur Datenübertragung für IrDA-Anwendungen zum Einsatz gebracht. Zur Datenübertragung mittels einer optischen Punkt-zu-Punkt-Übertragungsstrecke wurde der IrDA (Infrared Data Associaton) Standard entwickelt. Beispielsweise sind von der Firma TEMIC TELEFUNKEN micro-electronic GmbH unter der Bezeichnung TFDS 3000 beziehungsweise TFDS 6000 integrierte Transceiver-Bauteile erhältlich, die dem IrDA-Standard entsprechen.

Hierbei sind in einem gemeinsamen Gehäuse eines Transceivers ein Infrarotsender (Emitter), ein Infrarotempfänger (Detektor) und ein integrierter Schaltkreis zur Signalaufbereitung angeordnet. Eine Oberflächenseite des Transceiver-Bauteils weist zwei nebeneinanderliegende, linsenförmige Ausformungen auf, in deren Brennpunkt sich jeweils der Sender und der Empfänger befinden. Diese optischen Systeme sind notwendig, um die im IrDA-Standard geforderte gerichtete Signalabstrahlung des Senders und die gerichtete Empfindlichkeit des Empfängers zu erzielen. Ein derartiges optisches Sende-Empfangs-Modul mit einem Gehäuse mit zwei Linsen ist auch aus der DE 195 08 284 A bekannt.

Derartige Transceiver weisen den Nachteil auf, dass aufgrund der nebeneinanderliegenden Anordnung von Sender und Empfänger jeweils ein eigenes optisches System notwendig ist, um die geforderte gerichtete Signalabstrahlung des Senders und die gerichtete Empfindlichkeit des Empfängers zu erzielen. Das verursacht hohe Materialkosten, und die Dimensionen des Transceiver-Bauteils fallen relativ groß aus.

Zudem offenbart die GB 2 011 610 A ein Sende- und Empfangsmodul für einen Lichtwellenleiter mit einer bidirektionale konzentrische Anordnung und einem Emitterchip auf einem Detektorchip. Aus Patent Abstracts of Japan, Vol. 17, No. 4, 6.11.1993, JP 4237005 A, ist ein Empfängermodul für einen Lichtwellenleiter bekannt, mit einem Verstärker unter einem Detektor und einem Gehäuse mit einer Linse. Derartige Bauelemente sind jedoch nicht als Transceiver für die Datenübertragung nach dem IrDA-Standard geeignet.

Es ist deshalb Aufgabe der Erfindung, ein Bauteil anzugeben, dessen Dimensionen weitaus geringer ausfallen, so dass Materialkosten und Platzaufwand verringert werden.

Gelöst wird diese Aufgabe durch eine Anordnung mit den im Anspruch 1 angegebenen Merkmalen.

Die Vorteile der Erfindung liegen darin, dass für Sender und Empfänger ein gemeinsames optisches System verwendet werden kann, wodurch die Dimensionen des Bauteils erheblich verringert und Materialkosten eingespart werden. Zudem verringert sich durch kürzere Bonddrähte die Störempfindlichkeit des Bauteils.

Weitere vorteilhafte Weiterbildungen der Erfindung sind in den weiteren Unteransprüchen beschrieben.

Zwei Ausführungsbeispiele der Erfindung sind nachstehend ausführlich erläutert und anhand der Figuren dargestellt.

Es zeigen
- Fig. 1:: ein erfindungsgemäßer Transceiver in Seitenansicht,
- Fig. 2:: der Transceiver nach Fig. 1a in aufgeschnittener Darstellung,
- Fig. 3:: ein Transceiver nach dem Stand der Technik in perspektivischer Darstellung.

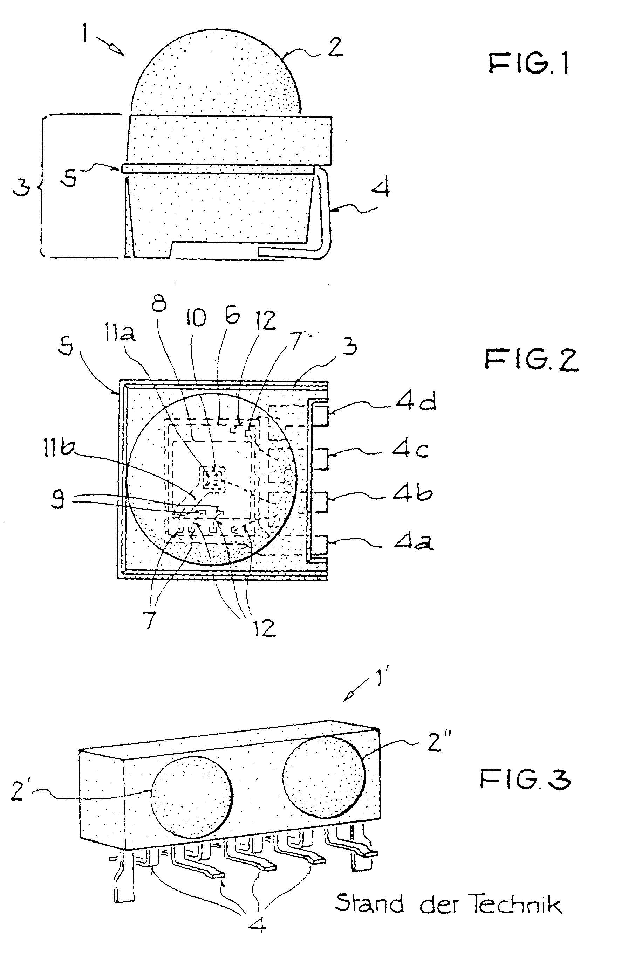

Die Fig. 1 und 2 zeigen einen Transceiver **1** mit einer Linse **2** als optisches System, einem beispielsweise aus thermo- oder duroplastischer und für IR-Strahlen transparenter Vergußmasse bestehenden Gehäuse **3** und Anschlußbeinchen **4,** die als Teil eines metallenen Streifenträgers **5** nach außen geführt sind. Hierbei ist das Anschlußbeinchen **4a** (GND) mit dem Bezugspotential verbunden, das Anschlußbeinchen **4b** (Vcc) mit der Versorgungsspannung, das Anschlußbeinchen **4c** (RxD) mit dem Dateneingang und das Anschlußbeinchen **4d** (TxD) mit dem Datenausgang einer (nicht dargestellten) Treiberschaltung.

Auf dem Träger **5** ist ein integrierter Schaltkreis **6** befestigt, der zur Verstärkung der Signale dient und der Pads **7** zur Kontaktierung aufweist. Über eine Rückseitenkontaktierung ist der integrierte Schaltkreis **6** mit dem Masseanschluß **4a** (GND) verbunden. Auf dem integrierten Schaltkreis **6** ist eine Photo-PIN-Diode als Empfänger- oder Detektorchip **8** angeordnet, die ebenfalls zur Kontaktierung Pads **9** aufweist. Bei dieser Photo-PIN-Diode handelt es sich um ein spezielles IrDA-Produkt, das aber mit einer für Photo-PIN-Dioden üblichen Technologie hergestellt ist. Um den Vorgang der späteren Kontaktierung zu erleichtern, sind die Pads **9** vorzugsweise auf der Vorderseite, d.h. auf der den zu empfangenden IR-Strahlen zugewandten Seite, angeordnet. Die Oberfläche des Detektorchips **8** weist eine bis zu seiner äußeren Begrenzung verlaufende Metallisierung **11b** auf, die als Montagefläche und Rückseitenkontakt für ein Sender- oder Emitterchip **10** und als Anschlußpad dient.

Auf das Detektorchip **9** ist konzentrisch das Sender- oder Emitterchip **10** aufgeklebt, bei dem es sich prinzipiell um eine bekannte infrarot-Sendediode handelt. Zur Kontaktierung ist eine im Zentrum des Emitterchips **10** angeordnete Kontaktfläche **11a** und das mittels einer leitenden Verbindung (Metallisierung) herausgeführte Anschlußpad **11b** vorhanden.

Die Fläche des integrierten Schaltkreises **6** ist größer als die Fläche des Detektorchips **8,** dessen Fläche wiederum größer ist als die Fläche des Emitterchips **10.** Zur Signalübertragung erfolgt die Kontaktierung zwischen den einzelnen Anschlußpads **7, 9, 11a** bzw. **11b** untereinander oder zu den Anschlüssen **4b, 4c** bzw. **4d** auf bekannte Art und Weise mittels Bonddrähten **12,** die aus Gold, Aluminium oder einer gut leitfähigen Legierung bestehen.

Zur Befestigung des integrierten Schaltkreises **6** auf dem Träger **5,** des Detektorchips **8** auf dem integrierten Schaltkreis **6** und des Emitterchips **10** auf dem Detektorchip **8** wird beispielsweise Polymidkleber, Lot, Kunststofflot oder ein anderer üblicher Kunststoffkleber verwendet. Um zu gewährleisten, daß das Emitterchip **10** leitend auf dem Detektorchip **8** befestigt ist, können dabei für die einzelnen Klebungen jeweils verschiedene Klebstoffe oder Lote Verwendung finden. Die Verbindung zwischen dem integrierten Schaltkreis **6** und dem Detektorchip **8** kann leitfähig oder nicht leitfähig sein, wobei der nicht leitfähigen Verbindung der Vorzug zu geben ist.

Das optische System **2,** bei dem es sich im einfachsten Fall um eine Kunststofflinse handelt, ist derart ausgestaltet, daß sowohl vom Emitterchip **10** ausgehende Strahlung optimal abgestrahlt wird, als auch einfallende Strahlung optimal auf das Detektorchip **8** gelenkt wird. Ermöglicht wird dies dadurch, daß Detektorchip **8** und Emitterchip **10** nicht wie bisher nebeneinander, sondern übereinander angeordnet sind. Dadurch ist es möglich, gegenüber dem Stand der Technik, bei dem jeweils für Emitter und Detektor ein eignes optisches System verwendet werden muß, ein optisches System einzusparen und die Breite des Transceivers **1** ungefähr zu halbieren.

Die Fig. 3 zeigt einen Transceiver **1'** nach dem Stand der Technik. Da (der nicht sichtbare) Detektorchip und (der ebenfalls nicht sichtbare) Emitterchip nebeneinander angeordnet sind, ist jeweils für den Emitterchip und den Detektorchip eine eigene Linse **2'** bzw. **2"** notwendig. Dadurch und daß die Anschlüsse **4** von Detektor und Emitter getrennt herausgeführt sind, vergrößert sich der Transceiver **1'** gegenüber der erfindungsgemäßen Anordnung auf ungefähr die doppelte Breite.

## Patentansprüche

1. Bauteil zur gerichteten, bidirektionalen optischen Datenübertragung, bei dem in einem ein- oder mehrteiligen Gehäuse (3) als Bauteile ein Emitterchip (10) zum Aussenden von IR-Strahlen, ein Detektorchip (8) zum Empfangen von IR-Strahlen, ein Integrierter Schaltkreis (6) zum Verstärken der Sendeund Empfangsleistung und ein optisches System (2) mit einer optischen Achse zur Bündelung der ausgesendeten und empfangenen Strahlen angeordnet sind, wobei den Detektorchip (8) und der Emitterchip (10) konzentrisch zur optischen Achse des optischen Systems (2) aufeinander und auf dem integrierten Schaltkreis (6) angeordnet sind, und die Oberfläche des Detektorchips (8) in ihrem Zentrum eine Metallisierung (11a, 11b) aufweist, die als Montagefläche (11b) für den Emitterchip (10) dient.

2. Bauteil nach Anspruch 1, **dadurch gekennzeichnet, dass** die Metallisierung (11b) auf dem Detektorchip (8) als Anschlusspad für einen Bonddraht (12) dient.

3. Bauteil nach Anspruch 1, **dadurch gekennzeichnet, dass** der Emitterchip (10) eine Rückseitenmetallisierung aufweist, die mittels Lot oder leitfähigem Kleber in Kontakt mit der Montagefläche (11b) steht.

4. Bauteil nach einem der Ansprüche 1 bis 3, **dadurch gekennzeichnet, dass** den Emitterchip (10) als oberstes Bauteil angeordnet ist.

5. Bauteil nach einem der Ansprüche 1 bis 4, **dadurch gekennzeichnet, dass** die Fläche des Integrierten Schaltkreises (6) größer als die Fläche des Detektorchips (8) und die Fläche des Detektorchips (8) größer als die Fläche des Emitterchips (10) ist.

6. Bauteil nach einem der Ansprüche 1 bis 5, **dadurch gekennzeichnet, dass** Bonddrähte (12) zwischen den Anschlußpads (7) des integrierten Schaltkreises (6) und den Anschlußpads (9) des Detektorchips (8), zwischen den Anschlußpads (7) des integrierten Schaltkreises (6) und der Metallisierung (11b) auf dem Detektorchip (8), zwischen den Anschlußpads (7) des integrierten Schaltkreises (6) und den Anschlußbeinchen (4) und/oder zwischen dem Anschlußpad (11a) des Emitterchips (10) und den Anschlußbeinchen (4) angeordnet sind.

7. Bauteil nach einem der Ansprüche 1 bis 6, **dadurch gekennzeichnet, dass** die Bauteile (6, 8, 10) auf einem Träger (5) montiert sind.

8. Bauteil nach Anspruch 7, **dadurch gekennzeichnet, dass** es sich bei dem Träger (5) um einen metallischen Streifenträger handelt.

9. Bauteil nach einem der vorangehenden Ansprüche, **dadurch gekennzeichnet, dass** das Gehäuse (3) aus einer thermo- oder duroplastischen und für IR-Strahlen transparenten Vergussmasse besteht.

## Claims

1. A component for directed, bi-directional optical transmission of data in which an emitter chip (10) for transmitting IR beams, a detector chip (8) for receiving IR beams, an integrated circuit (6) for amplifying the transmitting and receiving power and an optical system (2) having an optical axis for focusing the transmitted and received beams are arranged as components in a single or multi-part housing (3), wherein the detector chip (8) and the emitter chip (10) are arranged one on top of the other concentrically relative to the optical axis of the optical system (2) upon the integrated circuit (6), and a metallization (11a, 11b), which serves as the mounting surface (11b) for the emitter chip (10), is provided on the surface of the detector chip (8) at the centre thereof.

2. A component in accordance with Claim 1, **characterised in that** the metallization (11b) on the detector chip (8) serves as a terminal pad for a bonding wire (12).

3. A component in accordance with Claim 1, **characterised in that** the rear face of the emitter chip (10) is provided with a metallization which is connected to the mounting surface (11b) by means of solder or a conductive adhesive.

4. A component in accordance with any of Claims 1 to 3, **characterised in that** the emitter chip (10) forms the topmost component.

5. A component in accordance with any of Claims 1 to 4, **characterised in that** the surface area of the integrated circuit (6) is greater than the surface area of the detector chip (8), and the surface area of the detector chip (8) is greater than the surface area of the emitter chip (10).

6. A component in accordance with any of Claims 1 to 5, **characterised in that** bonding wires (12) are arranged between the terminal pads (7) of the integrated circuit (6) and the terminal pads (9) of the detector chip (8), between the terminal pads (7) of the integrated circuit (6) and the metallization (11b) on the detector chip (8), between the terminal pads (7) of the integrated circuit (6) and the terminal legs (4) and/or between the terminal pad (11a) of the emitter chip (10) and the terminal legs (4).

7. A component in accordance with any of Claims 1 to 6, **characterised in that** the components (6, 8, 10) are mounted on a support means (5).

8. A component in accordance with Claim 7, **characterised in that** the support means (5) is a metallic strip support.

9. A component in accordance with any of the preceding Claims, **characterised in that** the housing (3) consists of a thermoplastic or thermosetting potting compound that is transparent to IR radiation.

## Revendications

1. Composant pour la transmission optique bidirectionnelle dirigée de données, dans lequel comme composants une plaquette d'émetteur (10) pour émettre un rayonnement infrarouge, une plaquette de détecteur (8) pour recevoir le rayonnement infrarouge, un circuit intégré (6) pour amplifier la puissance d'émission et la puissance de réception et un système optique (2) possédant un axe optique pour focaliser les rayonnements émis et reçus sont disposés dans un boîtier (3) formé d'un ou de plusieurs éléments, et dans lequel la plaquette de détecteur (8) et la plaquette d'émetteur (10) sont disposés l'une sur l'autre et sur le circuit intégré (6) concentriquement par rapport à l'axe optique du système optique (2), et la surface de la plaquette de détecteur (8) comporte en son centre une métallisation (11a, 11b), qui est utilisée comme surface de montage (11b) pour la plaquette d'émetteur (10).

2. Composant selon la revendication 1, **caractérisé en ce que** la métallisation (11b) sur la plaquette de détecteur (8) sert de plot de connexion pour un fil de liaison (12).

3. Composant selon la revendication 1, **caractérisé en ce que** la plaquette d'émetteur (10) comporte une métallisation de face arrière, qui est en contact, au moyen d'une brasure ou d'une colle conductrice, avec la surface de montage (11b).

4. Composant selon l'une des revendications 1 à 3, **caractérisé en ce que** la plaquette d'émetteur (10) est disposée en tant que composant situé au niveau le plus élevé.

5. Composant selon l'une des revendications 1 à 4, **caractérisé en ce que** la surface du circuit intégré (6) est plus étendue que la surface de la plaquette de détecteur (8), et que la surface de la plaquette de détecteur (8) est plus étendue que la surface de la plaquette d'émetteur (10).

6. Composant selon l'une des revendications 1 à 5, **caractérisé en ce que** des fils de liaison (12) sont disposés entre les plots de connexion (7) du circuit intégré (6) et les plots de connexion (9) de la plaquette de détecteur (8), entre les plots de connexion (7) du circuit intégré (6) et la métallisation (11b) sur la plaquette de détecteur (8), entre les plots de connexion (7) du circuit intégré (6) et les pattes de raccordement (4) et/ou entre le plot de connexion (11a) de la plaquette d'émetteur (10) et les pattes de raccordement (4).

7. Composant selon l'une des revendications 1 à 6, **caractérisé en ce que** les composants (6, 8, 10) sont montés sur un support (5).

8. Composant selon la revendication 7, **caractérisé en ce qu'**en ce qui concerne le support (5), il s'agit d'un support métallique en forme de bande.

9. Composant selon l'une des revendications précédentes, **caractérisé en ce que** le boîtier (3) est constitué par une masse de scellement thermoplastique ou thermodurcissable et transparente pour le rayonnement infrarouge.
